(19) Europäisches Patentamt European Patent Office Office européen des brevets

(11) **EP 2 815 508 B1**

(12) **FASCICULE DE BREVET EUROPEEN**

(45) Date de publication et mention de la délivrance du brevet:
**14.04.2021   Bulletin 2021/15**

(21) Numéro de dépôt: **13703621.6**

(22) Date de dépôt: **13.02.2013**

(51) Int Cl.:
*H03M 13/11* $^{(2006.01)}$       *H04B 1/69* $^{(2011.01)}$
*H04L 27/20* $^{(2006.01)}$       *H04J 13/00* $^{(2011.01)}$

(86) Numéro de dépôt international:
**PCT/EP2013/052842**

(87) Numéro de publication internationale:
**WO 2013/120882 (22.08.2013 Gazette 2013/34)**

(54) **PROCEDE DE TRANSMISSION DE MOTS DE CODE CORRECTEUR D'ERREUR NON BINAIRE AVEC MODULATION CCSK, SIGNAL ET DISPOSITIF CORRESPONDANT**

VERFAHREN ZUR ÜBERTRAGUNG NICHT BINÄRER FEHLERKORREKTURCODEWÖRTER MIT CCSK-MODULATION, ENTSPRECHENDES SIGNAL UND ENTSPRECHENDE VORRICHTUNG

METHOD FOR TRANSMITTING NON BINARY ERROR CORRECTING CODE WORDS WITH CCSK MODULATION, AND CORRESPONDING SIGNAL AND DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.02.2012   FR 1251334**

(43) Date de publication de la demande:
**24.12.2014   Bulletin 2014/52**

(73) Titulaires:
  • **Universite De Bretagne Sud**
    **56100 Lorient (FR)**
  • **Centre National de la Recherche Scientifique (C.N.R.S.)**
    **75794 Paris Cedex 16 (FR)**

(72) Inventeurs:
  • **BOUTILLON, Emmanuel**
    **F-56100 Lorient (FR)**
  • **CONDE-CANENCIA, Laura**
    **F-56100 Lorient (FR)**
  • **ABASSI, Oussama**
    **38400 SAINT-MARTIN d'HERES (FR)**

(74) Mandataire: **Plasseraud IP**
    **66, rue de la Chaussée d'Antin**
    **75440 Paris Cedex 09 (FR)**

(56) Documents cités:
  • **CHI-HAN KAO ET AL: "Performance analysis and simulations of 32-ary cyclic code-shift keying", INTERNATIONAL JOURNAL OF COMMUNICATION SYSTEMS, vol. 24, no. 2, 28 août 2010 (2010-08-28), pages 258-268, XP055034685, ISSN: 1074-5351, DOI: 10.1002/dac.1153**
  • **YIN HOE NG ET AL: "Single-Carrier Cyclic Prefix-Assisted PLC Systems With Frequency-Domain Equalization for High-Data-Rate Transmission", IEEE TRANSACTIONS ON POWER DELIVERY, IEEE SERVICE CENTER, NEW YORK, NY, US, vol. 25, no. 3, 1 juillet 2010 (2010-07-01), pages 1450-1457, XP011306725, ISSN: 0885-8977**
  • **GEORGE M. DILLARD ET AL: "Cyclic Code Shift Keying: A Low Probability of Intercept Communication Technique", IEEE TRANSACTIONS ON AEROSPACE AND ELECTRONIC SYSTEMS, vol. 39, no. 3, 1 juillet 2003 (2003-07-01), pages 786-798, XP055034687,**

**Description**

La présente invention concerne un procédé de transmission de symboles de mots de code correcteur d'erreur non binaire en vue de leur transmission dans un canal de communication. Ces codes sont définis sur des ensembles non binaires. L'invention trouve par exemple une application dans la transmission de codes LDPC (Low Density Parity Check en langue anglaise) non binaires ou de codes de Reed-Salomon. L'invention concerne également le signal correspondant transmis et la réception d'un tel signal.

L'invention sera plus particulièrement décrite dans le cadre de codes LDPC non binaires. Les codes LDPC sont des codes correcteurs d'erreur connus pour approcher la limite théorique de Shannon. En raison de leurs performances en termes d'immunité au bruit, les codes LDPC, et notamment les codes LDPC non binaires, peuvent trouver une application dans de nombreux systèmes, par exemple dans les systèmes de communication sans fil, la fibre optique, le câble, les systèmes de stockage de données numériques...

Les codes LDPC non binaires, appelés aussi codes NB-LDPC, sont construits dans un corps de Galois non binaire d'ordre q, noté classiquement GF(q). L'ordre q est généralement une puissance de 2, par exemple $q=2^p$. Un code LDPC dans GF(q) est défini par une matrice de parité H creuse de dimension A x B dont les éléments appartiennent à GF(q), A étant le nombre de contraintes de parité et B étant le nombre d'éléments de GF(q) dans le mot de code. Pour un corps de Galois GF(4) composé de 4 éléments $\{0, \alpha^0, \alpha^1, \alpha^2\}$, la matrice de parité pour A=3 et B=6 est par exemple la suivante:

$$ H = \begin{pmatrix} 0 & \alpha^0 & \alpha^0 & 0 & \alpha^2 & 0 \\ \alpha^1 & 0 & 0 & \alpha^0 & 0 & \alpha^2 \\ \alpha^0 & 0 & \alpha^2 & 0 & 0 & \alpha^1 \end{pmatrix} $$

Cette matrice peut également être représentée par un graphe bipartite (graphe de Tanner) ayant A nœuds de parité et B nœuds de variable recevant les symboles du mot de code. Chaque colonne de la matrice de parité est associée à un nœud de variable et chaque ligne de la matrice est associée à un nœud de parité.

En vue de leur transmission dans un canal de communication qui est généralement bruité, il est connu de moduler les codes LDPC non binaires avec une modulation M-aire orthogonale à étalement de spectre comme décrit dans le document intitulé "Combine Non-Binary LDPC codes with M-ary Orthogonal spread spectrum modulation" Yuzhen Huang, Yun-peng Cheng, Yu-ming Zhang, Guo-hai Yu, Jin Chen, 2010 International Conférence on Wireless Communications and Signal Processing (WCSP), 2010. L'utilisation d'une modulation à étalement de spectre permet notamment d'avoir une meilleure immunité aux bruits.

Ce document divulgue plus particulièrement de moduler les symboles des mots de code NB-LDPC avec une modulation orthogonale à étalement de spectre utilisant $2^M$ séquences de Walsh-Hadamard orthogonales entre elles, avec $2^M$ égal à l'ordre $q(=2^p)$ du corps de Galois GF(q) des codes LDPC non binaires et M égal au nombre p de bits de chacun des symboles du corps de Galois GF(q). La taille $2^M$ de la constellation de la modulation orthogonale est prise égale au nombre $q=2^p$ de symboles du corps des codes NB-LDPC pour qu'il n'y ait pas de perte d'information à la démodulation. Dans ce document, la démodulation est relativement complexe à réaliser puisqu'elle nécessite de faire des calculs d'inter-corrélation (ou "cross-correlations" en langue anglaise) entre chacune des $2^p$ séquences de Walsh-Hadamard et le signal bruité, ce qui représente un coût en termes d'implémentation. Dans ce document, la démodulation est réalisée au moyen de $2^p$ filtres adaptés associés chacun à une séquence de Walsh-Hadamard prédéterminée.

Le document Chi-Han Kao et al.: "Performance analysis and simulations of 32-ary cyclic code-shift keying", décrit l'utilisation d'une modulation CCSK.

Un but de l'invention est de pallier l'inconvénient précité.

Selon l'invention, on propose d'utiliser une modulation à décalage de code cyclique (ou CCSK pour Cyclic Code-Shift Keying en langue anglaise), au lieu d'une modulation M-aire orthogonale, pour étaler le spectre du signal émis.

Plus particulièrement, l'invention concerne un procédé de transmission de symboles de mot de code correcteur d'erreur non binaire à travers un canal de transmission, chaque symbole de mot de code comprenant p bits, lequel procédé comprend une première étape de modulation associant à chaque symbole de mot de code de p bits une séquence d'au moins $2^p$ bribes parmi $2^p$ séquences possibles, une deuxième étape de modulation pour moduler la phase ou l'amplitude d'au moins une porteuse avec les séquences associées aux mots de code et une étape de transmission de la porteuse modulée à travers ledit canal de transmission, remarquable en ce que la première étape de modulation est une modulation à étalement de spectre de type modulation par décalage de code cyclique utilisant une séquence pseudo-aléatoire de base d'au moins $2^p$ bribes, les $2^p$ séquences possibles étant obtenues par décalage circulaire de la séquence pseudo-aléatoire de base et en ce que le procédé comprend en outre, après ladite deuxième étape de modulation, une étape d'insertion d'un préfixe cyclique dans chaque symbole à transmettre.

Avec ce procédé, la démodulation en réception peut être effectuée par des opérations simples de transformée de Fourier rapide (OU FFT en langue anglaise) et de transformée de Fourier rapide inverse (ou IFFT en langue anglaise). Par ailleurs, ce procédé ne requiert qu'un seul générateur pseudo-aléatoire pour générer les $2^p$ séquences.

La séquence pseudo-aléatoire de base est générée, au moins partiellement, par un registre à décalage rebouclé implémentant un polynôme primitif d'ordre p.

Les mots de code traités sont par exemple des mots de code LDPC non binaire ou des mots de code de Reed Salomon non binaire.

L'invention concerne également un dispositif d'émission de symboles de mots de code correcteur d'erreur non binaire à travers un canal de transmission, chaque symbole de mot de code comprenant p bits, lequel dispositif comprend un premier modulateur associant à chaque symbole de mot de code de p bits une séquence d'au moins $2^p$ bribes parmi $2^p$ séquences possibles, un deuxième modulateur pour moduler la phase ou l'amplitude d'une porteuse avec les séquences associées aux mots de code, et un émetteur pour transmettre la porteuse modulée à travers ledit canal de transmission, remarquable en ce que le premier modulateur est un modulateur à étalement de spectre de type à décalage de code cyclique utilisant une séquence pseudo-aléatoire de base d'au moins $2^p$ bribes, les $2^p$ séquences possibles étant obtenues par décalage circulaire de la séquence pseudo-aléatoire de base et ce qu'il comporte en outre un circuit apte à insérer un préfixe cyclique dans chaque symbole à transmettre.

L'invention concerne aussi un signal de code correcteur d'erreur non binaire destiné à être transmis par le procédé défini précédemment.

L'invention concerne également un procédé de réception d'un signal de code correcteur d'erreur non binaire transmis sur une porteuse unique par le procédé défini précédemment, caractérisé en ce qu'il comprend une étape de réception du signal, une étape de suppression du préfixe cyclique de chaque symbole, une étape de transformée de Fourier rapide du signal reçu pour générer des échantillons dans le domaine fréquentiel, et une étape d'égalisation fréquentielle et de calcul de valeurs de logarithmes de rapport de vraisemblance desdits échantillons.

En effet, l'utilisation de la modulation par décalage de code cyclique et l'insertion d'un préfixe cyclique dans chaque symbole à transmettre est plus particulièrement adaptée aux systèmes de communication sans fil à porteuse unique car l'égalisation fréquentielle et le calcul des valeurs de logarithmes de rapport de vraisemblance peuvent alors être réalisés par les mêmes opérations de FFT et IFFT.

Enfin, l'invention concerne également un dispositif de réception d'un signal de code correcteur d'erreur non binaire transmis sur une porteuse unique par le dispositif d'émission défini précédemment, caractérisé en ce qu'il comprend un récepteur du signal transmis, un circuit apte à supprimer le préfixe cyclique de chaque symbole, un circuit de transformée de Fourier rapide du signal reçu pour générer des échantillons dans le domaine fréquentiel, et un circuit d'égalisation fréquentielle et de calcul de valeurs de logarithmes de rapport de vraisemblance desdits échantillons.

L'invention sera mieux comprise, et d'autres buts, détails, caractéristiques et avantages apparaîtront plus clairement au cours de la description explicative détaillée qui va suivre, en se référant ci-dessus aux dessins annexés, lesquels représentent:

- la figure 1, un schéma fonctionnel d'un traitement de signal conforme à l'invention comprenant une étape de modulation CCSK utilisant une séquence pseudo-aléatoire de base;
- la figure 2, une courbe illustrant la corrélation d'une séquence pseudo-aléatoire de base avec une version décalée de cette séquence;
- la figure 3, un schéma fonctionnel illustrant le calcul des valeurs de logarithme de rapport de vraisemblance en réception;
- la figure 4, des courbes illustrant le taux d'erreur par trame en réception, avec et sans modulation CCSK en transmission, pour un canal gaussien;
- la figure 5, un diagramme fonctionnel illustrant l'émission et la réception de codes NB-LDPC à travers un canal à trajets multiples, dans le cas d'une modulation à porteuse unique précédée d'une modulation CCSK;
- la figure 6, un diagramme fonctionnel illustrant l'émission et la réception de codes NB-LDPC à travers un canal à trajets multiples, dans le cas d'une modulation OFDM précédée d'une modulation CCSK; et
- la figure 7, des courbes illustrant le taux d'erreur binaire en réception dans le cas de la modulation à porteuse unique et le cas de la modulation OFDM.

Selon l'invention, il est proposé de moduler les symboles des mots de code NB-LDPC délivrés par un codeur NB-LDPC avec une modulation par décalage de code cyclique, appelée couramment modulation CCSK (pour "Cyclic Code Shift Keying" en langue anglaise), utilisant une séquence pseudo-aléatoire comprenant au moins $2^p$ bribes (ou "chips" en langue anglaise). Le terme bribe désigne une information binaire dans le code d'une modulation à étalement de spectre.

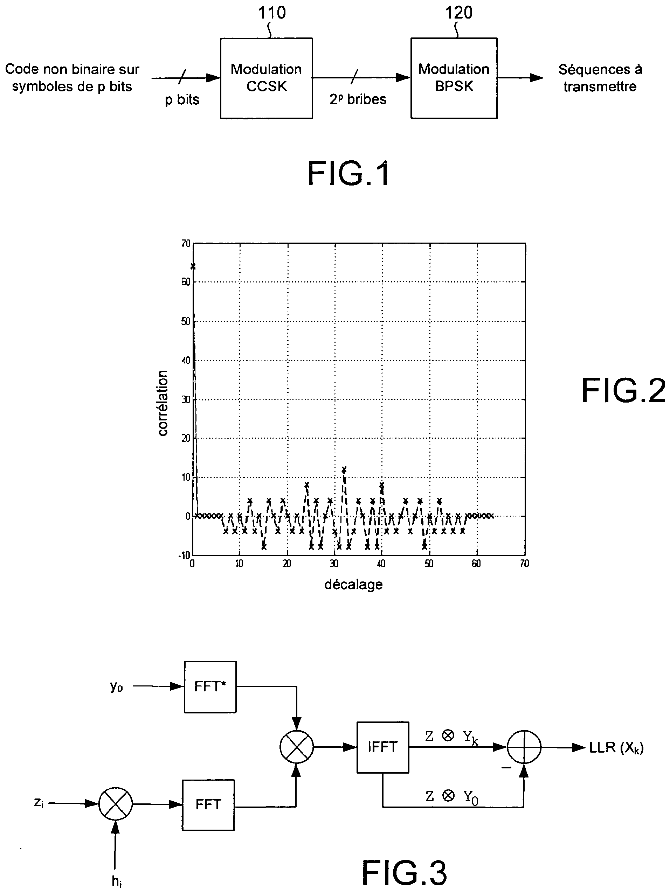

La figure 1 illustre les étapes du procédé de l'invention. Selon une étape référencée 110, les codes NB-LDPC sont modulés avec une modulation CCSK dont la fonction est d'associer à chaque symbole de mot de code NB-LDPC de p bits une séquence pseudo-aléatoire comprenant $2^p$ bribes. Puis, selon une étape référencée 120, les séquences issues de l'étape 110 sont modulées par une modulation numérique, dont la fonction est de moduler au moins une porteuse avec les séquences produites issues de l'étape 110. Dans l'exemple de la figure 1, la modulation de l'étape 120 est une modulation BPSK (pour "Binary Phase-Shift Keying" en langue anglaise). Dans cet exemple, les séquences produites à l'étape 110 modulent la phase de la porteuse. Des modulations, autres que la modulation BPSK, modulant la phase ou l'amplitude de la porteuse sont bien entendu possibles pour l'étape 120.

Pendant l'étape 110, à chaque symbole de p bits est associée une séquence d'au moins $2^p$ bribes. Plus particulièrement, chaque symbole de p bits est converti en une séquence particulière obtenue par décalage circulaire d'une séquence pseudo-aléatoire de base notée $PN_0$. Ainsi, les calculs à effectuer en réception pour déterminer la séquence transmise sont des calculs d'autocorrélation. Ces calculs d'autocorrélation peuvent être exécutés par des opérations de FFT et IFFT, ce qui contribue à simplifier le traitement de signal en réception.

Un exemple de modulation CCSK est décrit ci-après pour des symboles de 6 bits appartenant au corps de Galois GF($64=2^6$). Comme les symboles comportent 6 bits, la séquence pseudo-aléatoire doit comprendre au moins $64=2^6$ bribes pour qu'il n'y ait pas de perte d'information. La séquence pseudo-aléatoire de base $PN_0$ est sélectionnée de manière à présenter de bonnes performances en termes d'auto-corrélation. Plusieurs méthodes sont connues dans la littérature pour y parvenir. Dans le cas présent, une séquence de 63 bribes est générée par un registre à décalage rebouclé, aussi appelé registre LFSR (pour Linear feedback Shift Register en langue anglaise), à laquelle on rajoute une bribe supplémentaire pour obtenir une séquence pseudo-aléatoire de 64 bribes. Ce bit supplémentaire est rajouté à n'importe quel emplacement dans la séquence. D'autres méthodes de génération de séquences pseudo-aléatoires sont possibles.

La séquence pseudo-aléatoire de base $PN_0$ est par exemple la séquence suivante de 64 bits:
1000001000011000101001111010001110010010110111011001101010111111

Cette séquence est générée par un registre LFSR implémentant le polynôme irréductible P(x)=$1+x+x^6$ et un bit supplémentaire.

Les propriétés d'auto-corrélation de cette séquence $PN_0$ sont illustrées par la courbe de la figure 2 obtenue avec une modulation BPSK telle que BPSK(x)=1-2x avec x $\in$ {0, 1}. Comme on peut le voir sur cette figure, l'auto-corrélation de cette séquence pseudo-aléatoire de base, après modulation BPSK, présente un pic principal unique lorsque le décalage est nul et des pics secondaires non nuls. On peut donc en déduire que la modulation CCSK n'est pas orthogonale. Par ailleurs, cette séquence présente de bonnes performances d'autocorrélation puisque la distance entre le pic principal et les pics secondaires (décalages de 24, 32 et 40 bribes) est relativement grande.

A partir de cette séquence $PN_0$, on génère 63 autres séquences en décalant circulairement la séquence $PN_0$, chaque séquence étant associée à un élément du corps de Galois GF(64). La séquence $PN_0$ est associée à l'élément nul du corps de Galois GF(64). Les autres éléments $\alpha^k$ de GF(64), avec k E [0,62], sont obtenus en décalant circulairement la séquence $PN_0$ de k+1 positions vers la droite.

Le tableau récapitulatif ci-dessous montre les séquences de 64 bribes associées à chacun des éléments du corps de Galois GF(64):

| Symboles de GF ($64=2^6$) | Représentation binaire des éléments | Séquences CCSK de 64 bribes |
|---|---|---|
| 0 | 000000 | 1000001000011000101001111010001110010010110111011001101010111111 |
| $\alpha^0$ | 000001 | 1100000100001100010100111101000111001001011011101100110101011111 |
| $\alpha^1$ | 000010 | 1110000010000110001010011110100011100100101101110110011010101111 |
| $\alpha^2$ | 000100 | 1111000001000011000101001111010001110010010110111011001101010111 |
| $\alpha^3$ | 001000 | 1111100000100001100010100111101000111001001011011101100110101011 |
| $\alpha^4$ | 010000 | 1111110000010000110001010011110100011100100101101110110011010101 |
| $\alpha^5$ | 100000 | 1111111000001000011000101001111010001110010010110111011001101010 |
| $\alpha^6$ | 000011 | 0111111100000100001100010100111101000111001001011011101100110101 |
| $\alpha^7$ | 000110 | 1011111110000010000110001010011110100011100100101101110110011010 |
| $\alpha^8$ | 001100 | 0101111111000001000011000101001111010001110010010110111011001101 |
| $\alpha^9$ | 011000 | 1010111111100000100001100010100111101000111001001011011101100110 |

(suite)

| Symboles de GF (64=2^6) | Représentation binaire des éléments | Séquences CCSK de 64 bribes |
|---|---|---|
| $\alpha^{10}$ | 110000 | 0101011111100000100011000101001111010001110010010110111011001 |
| $\alpha^{11}$ | 100011 | 1010101111110000010001100010100111101000111001001011011011001 |
| $\alpha^{12}$ | 000101 | 1101010111111000001000011000101001111010001110010010110111011100 |
| $\alpha^{13}$ | 001010 | 0110101011111100000100001100010100111101000111001001011011101110 |
| $\alpha^{14}$ | 010100 | 0011010101111110000010000110001010011110100011100100101101110110 |
| $\alpha^{15}$ | 101000 | 1001101010111111000001000011000101001111010001110010010110111011 |
| $\alpha^{16}$ | 010011 | 1100110101011111100000100001100010100111101000111001001011011101 |
| $\alpha^{17}$ | 100110 | 0110011010101111110000010000110001010011110100011100100101101110 |
| $\alpha^{18}$ | 001111 | 1011001101010111111000001000011000101001111010001110010010110111 |
| $\alpha^{19}$ | 011110 | 1101100110101011111110000010000110001010011110100011100100101101 |
| $\alpha^{20}$ | 111100 | 1110110011010101111111000001000011000101001111010001110010010110 |
| $\alpha^{21}$ | 111011 | 0111011001101010111111100000100001100010100111101000111001001011 |
| $\alpha^{22}$ | 110101 | 1011101100110101011111110000010000110001010011110100011100100101 |
| $\alpha^{23}$ | 101001 | 1101110110011010101111111000001000011000101001111010001110010010 |
| $\alpha^{24}$ | 010001 | 0110111011001101010111111100000100001100010100111101000111001001 |
| $\alpha^{25}$ | 100010 | 1011011101100110101011111110000010000110001010011110100011100100 |
| $\alpha^{26}$ | 000111 | 0101101110110011010101111111000001000011000101001111010001110010 |
| $\alpha^{27}$ | 001110 | 0010110111011001101010111111100000100001100010100111101000111001 |
| $\alpha^{28}$ | 011100 | 1001011011101100110101011111110000010000110001010011110100011100 |
| $\alpha^{29}$ | 111000 | 0100101101110110011010101111111000001000011000101001111010001110 |
| $\alpha^{30}$ | 110011 | 0010010110111011001101010111111100000100001100010100111101000111 |
| $\alpha^{31}$ | 100101 | 1001001011011101100110101011111110000010000110001010011110100011 |
| $\alpha^{32}$ | 001001 | 1100100101101110110011010101111111000001000011000101001111010001 |
| $\alpha^{33}$ | 010010 | 1110010010110111011001101010111111100000100001100010100111101000 |
| $\alpha^{34}$ | 100100 | 0111001001011011101100110101011111110000010000110001010011110100 |
| $\alpha^{35}$ | 001011 | 0011100100101101110110011010101111111000001000011000101001111010 |
| $\alpha^{36}$ | 010110 | 0001110010010110111011001101010111111100000100001100010100111101 |
| $\alpha^{37}$ | 101100 | 1000111001001011011101100110101011111110000010000110001010011110 |
| $\alpha^{38}$ | 011011 | 0100011100100101101110110011010101111111000001000011000101001111 |
| $\alpha^{39}$ | 110110 | 1010001110010010110111011001101010111111100000100001100010100111 |
| $\alpha^{40}$ | 101111 | 1101000111001001011011101100110101011111110000010000110001010011 |
| $\alpha^{41}$ | 011101 | 1110100011100100101101110110011010101111111000001000011000101001 |
| $\alpha^{42}$ | 111010 | 1111010001110010010110111011001101010111111100000100001100010100 |
| $\alpha^{43}$ | 110111 | 0111101000111001001011011101100110101011111110000010000110001010 |
| $\alpha^{44}$ | 101101 | 0011110100011100100101101110110011010101111111000001000011000101 |
| $\alpha^{45}$ | 011001 | 1001111010001110010010110111011001101010111111100000100001100010 |

5

(suite)

| Symboles de GF (64=2⁶) | Représentation binaire des éléments | Séquences CCSK de 64 bribes |
|---|---|---|
| $\alpha^{46}$ | 110010 | 0100111101000111001001011011101100110101011111110000010000110001 |
| $\alpha^{47}$ | 100111 | 1010011110100011100100101101110110011010101111111000001000011000 |
| $\alpha^{48}$ | 1001101 | 0101001111010001110010010110111011001101010111111100000100001100 |
| $\alpha^{49}$ | 011010 | 0010100111101000111001001011011101100110101011111110000010000110 |
| $\alpha^{50}$ | 110100 | 0001010011110100011100100101101110110011010101111111000001000011 |
| $\alpha^{51}$ | 101011 | 1000101001111010001110010010110111011001101010111111100000100001 |
| $\alpha^{52}$ | 010101 | 1100010100111101000111001001011011101100110101011111110000010000 |
| $\alpha^{53}$ | 101010 | 0110001010011110100011100100101101110110011010101111111000001000 |
| $\alpha^{54}$ | 010111 | 0011000101001111010001110010010110111011001101010111111100000100 |
| $\alpha^{55}$ | 101110 | 0001100010100111101000111001001011011101100110101011111110000010 |
| $\alpha^{56}$ | 011111 | 0000110001010011110100011100100101101110110011010101111111000001 |
| $\alpha^{57}$ | 111110 | 1000011000101001111010001110010010110111011001101010111111100000 |
| $\alpha^{58}$ | 111111 | 0100001100010100111101000111001001011011101100110101011111110000 |
| $\alpha^{59}$ | 111101 | 0010000110001010011110100011100100101101110110011010101111111000 |
| $\alpha^{60}$ | 111001 | 0001000011000101001111010001110010010110111011001101010111111100 |
| $\alpha^{61}$ | 110001 | 0000100001100010100111101000111001001011011101100110101011111110 |
| $\alpha^{62}$ | 100001 | 0000010000110001010011110100011100100101101110110011010101111111 |

Nous allons à présent décrire la démodulation du signal ainsi modulé après transmission du signal dans un canal bruité et plus particulièrement dans un canal de Rayleigh à évanouissements lents non sélectif en fréquence.

Dans la suite de la description, on utilise les notations suivantes:

- $X \in GF(64)$ est un symbole quelconque de mot de code;
- $Y = [y_0, y_1, ..., y_{63}]$ est le signal BPSK d'une séquence CCSK quelconque;
- $PN_k = [p_0^k, p_1^k, ..., p_{63}^k]$ est la séquence obtenue par décalage de la séquence $PN_0$ de k positions, avec $k \in [0,63]$ ; $\forall i \in [0,63]$, $PN_0[i] = PN_k[(i+k) \bmod 64]$ ;
- $X_k = [x_0^k, x_1^k, ..., x_5^k]$ est le symbole de 6 bits qui correspond à la séquence $PN_k$; $X_k \in GF(64)$;
- $Y_k = [y_0^k, y_1^k, ..., y_{63}^k]$ est le signal BPSK de la séquence $PN_k$ ; et
- $Z = [z_0, z_1, ..., z_{63}]$ est le signal bruité reçu avec $z_i \in \Re, \forall i \in [0,63]$ .

Le canal de transmission considéré étant un canal de Rayleigh non sélectif en fréquence, la représentation discrète du signal reçu est de la forme:

$$\forall i \in [0,63], \quad z_i = h_i \cdot y_i + n_i$$

où

- $n_i$ est un échantillon de bruit blanc gaussien blanc ou AWGN (pour Additive White Gaussian Noise en langue anglaise) comprenant des échantillons indépendants et identiquement distribués ayant une moyenne nulle et une densité spectrale de puissance $N_0/2$; et
- $h_i$ est décrit par la fonction de densité de probabilité de Rayleigh suivante:

$$P(h_i) = 2 \cdot h_i \cdot e^{-k_i^2}$$

pour $h_i > 0$

$H=[h_0, h_1, ..., h_{63}]$ désigne l'ensemble des facteurs de Rayleigh associé à un symbole reçu de 64 bribes. Si $h_i=1$ $\forall i \in$ **[0, 63],** le canal est un canal AWGN.

Par ailleurs, l'état du canal de transmission est supposé connu par le dispositif de réception. La transmission des informations d'état du canal est considérée comme idéale. En réception, chaque signal $z_i$ est égalisé par le facteur $h_i$ associé.

Pour décoder le signal reçu, le décodeur doit recevoir en entrée des valeurs de logarithme de rapport de vraisemblance ou valeurs LLR (pour Log-Likelihood Ratio en langue anglaise). L'expression mathématique de ces valeurs LLR est la suivante :

$$\begin{aligned} LLR(X_k) &= \ln\left(\frac{P(Z_{/\,(H,\,X=X_k)})}{P(Z_{/\,(H,\,X=X_0)})}\right) \qquad (1) \\ &= \ln\left(\frac{P(Z_{/\,(H,\,Y=Y_k)})}{P(Z_{/\,(H,\,Y=Y_0)})}\right) \\ &= \ln\left(\frac{\Pi_{i=0}^{63}\ P(Z_{i/\,(h_i,\,y_i=y_i^k)})}{\Pi_{i=0}^{63}\ P(Z_{i/\,(h_i,\,y_i=y_i^0)})}\right) \end{aligned}$$

Or, $P(Z_{i\,/\,(h_i,\,y_i=y_i^k)}) = \dfrac{1}{\sqrt{2 \cdot \pi \cdot \sigma^2}} \cdot \exp\left(-\dfrac{(z_i - h_i \cdot y_i^k)^2}{2 \cdot \sigma^2}\right)$

On obtient alors:

$$LLR(X_k) = \frac{1}{\sigma^2} \cdot \sum_{i=0}^{63} (h_i \cdot y_i^k \cdot z_i) - \frac{1}{\sigma^2} \cdot \sum_{i=0}^{63} (h_i \cdot y_i^0 \cdot z_i)$$

La variance $\sigma$ du canal étant un terme constant, ce terme peut être supprimé pour simplifier les calculs. On obtient alors l'expression simplifiée

$$LLR(X_k) = \sum_{i=0}^{63} (h_i \cdot y_i^k \cdot z_i) - \sum_{i=0}^{63} (h_i \cdot y_i^0 \cdot z_i)$$

Chacune des deux sommes dans l'expression ci-dessus est la corrélation entre le signal reçu pondéré par les coefficients de Rayleigh et une des séquences CCSK possibles. Par conséquent, il est possible de calculer les LLRs en utilisant des opérations de FFT et IFFT comme représenté sur la figure 3.

On calcule le conjugué complexe de la FFT de la séquence $Y_0$ et la FFT du signal reçu $Z$ pondéré par les coefficients de Rayleigh $H$. L'IFFT du produit de ces deux résultats est ensuite calculée pour obtenir les valeurs de corrélation requises, soit $Z \otimes Y_k$. On soustrait enfin la valeur de corrélation de $Z \otimes Y_0$ des valeurs de corrélations $Z \otimes Y_k$ pour obtenir la valeur LLR $(X_k)$. Dans cet exemple, on obtient $LLR(X_0)=0$. En variante, il est possible de remplacer dans l'expression (1) de $LLR(X_k)$ le terme $P(Z_{/(H,X=X0)})$ par le terme ayant la plus faible valeur. Dans ce cas, les valeurs des LLRs sont toutes positives.

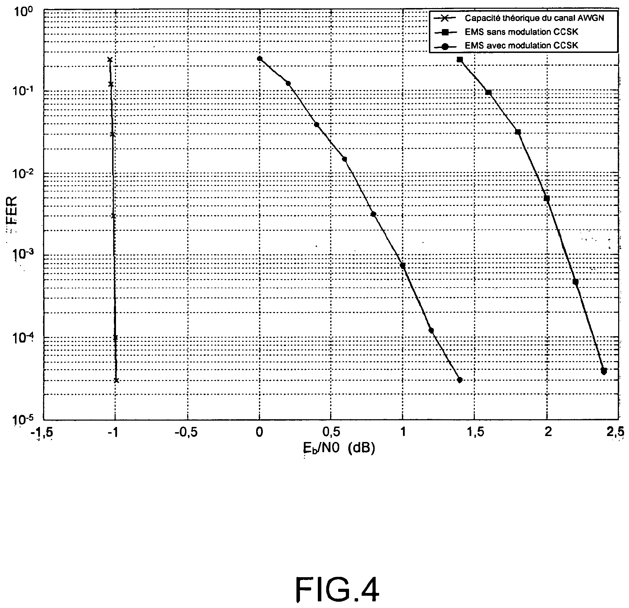

Les performances de ce traitement sont illustrées par les courbes de la figure 4. Le taux d'erreur par trame FER (pour Frame Error Rate en langue anglaise) est évalué sur un canal affecté par un bruit blanc gaussien additif (AWGN) avec ou sans modulation CCSK.

L'algorithme de décodage employé pour obtenir ces courbes est un algorithme de type EMS (pour Extended Min Sum en langue anglaise) bien connu de l'homme du métier et qui est décrit de manière détaillée dans le document intitulé "Algorithmes simplifiés pour le décodage de codes LDPC non binaires" de A.Voicila, D.Declercq, M.Fossorier et F.Verdier, GRETSI, Louvain-la-Neuve, Belgique, Septembre 2005. Cet algorithme est un algorithme sous-optimal destiné à réduire la complexité du décodage. Pour chaque itération de décodage, les nœuds de variable et les nœuds de parité n'échangent que les $n_m$ valeurs LLR les plus fiables.

La figure 4 présente des résultats de simulation sous forme de courbes:

- une première courbe illustre les performances du décodage sans modulation CCSK;
- une deuxième courbe illustre les performances du décodage avec modulation CCSK; et
- une troisième courbe illustre les performances d'un canal théorique AWGN.

Les simulations sont réalisées avec les paramètres de codage et de décodage suivants:

- les codes NB-LDPC appartiennent au corps de Galois GF(64);
- la longueur des codes NB-LDPC est égal à 192 symboles, soit 192x6 bits;
- le taux de codage (rapport entre les bits d'information utile et l'ensemble des bits transmis) est égal à 0,5;
- le degré des lignes et le degré des colonnes de la matrice de parité employée pour le codage et le décodage sont respectivement de 4 et de 2;
- l'algorithme EMS ne prend en compte que les 24 valeurs de LLR les plus fiables;
- le nombre maximum d'itérations pour le décodage est limité à 8; et
- la séquence pseudo-aléatoire employée pour la modulation CCSK est la séquence $PN_0$ défini précédemment.

La troisième courbe illustrant les performances d'un canal AWGN théorique correspond à la transmission d'un code de longueur 196x64 bits et un taux de codage de 3/64. Ces deux valeurs correspondent respectivement à la longueur de code effective et au taux de codage effectif du codage NB-LDPC avec modulation CCSK.

Ces courbes donnent le taux d'erreur par trame FER en fonction du rapport $E_b/N_0$ exprimé en décibels, où $E_b$ est l'énergie transmise par bit et $N_0$ est la densité spectrale du bruit.

A partir de ces courbes, on observe que la modulation CCSK améliore les performances du décodage. Cette amélioration s'explique par la diversité introduite par la modulation CCSK. La modulation CCSK augmente la longueur de code effective et on passe de 192x6 bits sans modulation CCSK à 192x64 bribes avec modulation CCSK.

Par ailleurs, comme indiqué précédemment, le calcul des valeurs de LLR est effectué dans le domaine fréquentiel via des opérations de FFT et de IFFT. Cette propriété de la modulation CCSK est très intéressante dans le domaine des systèmes de communication sans fil utilisant une porteuse unique avec égalisation dans le domaine fréquentiel ou SC-FDE (pour Single Carrier-Frequency Domain Equalization en langue anglaise). En effet, les valeurs de FFT calculés pour le signal reçu peuvent alors servir à la fois pour le calcul des valeurs de LLR et l'égalisation fréquentielle. Dans le domaine des systèmes de communication sans fil, cela procure aux systèmes à porteuse unique de type SC-FDE un avantage sur les systèmes à porteuses multiples de type OFDM (pour Orthogonal Frequency Division Multiplexing en langue anglaise) dans lesquels l'égalisation est effectuée sur une représentation temporelle du signal reçu.

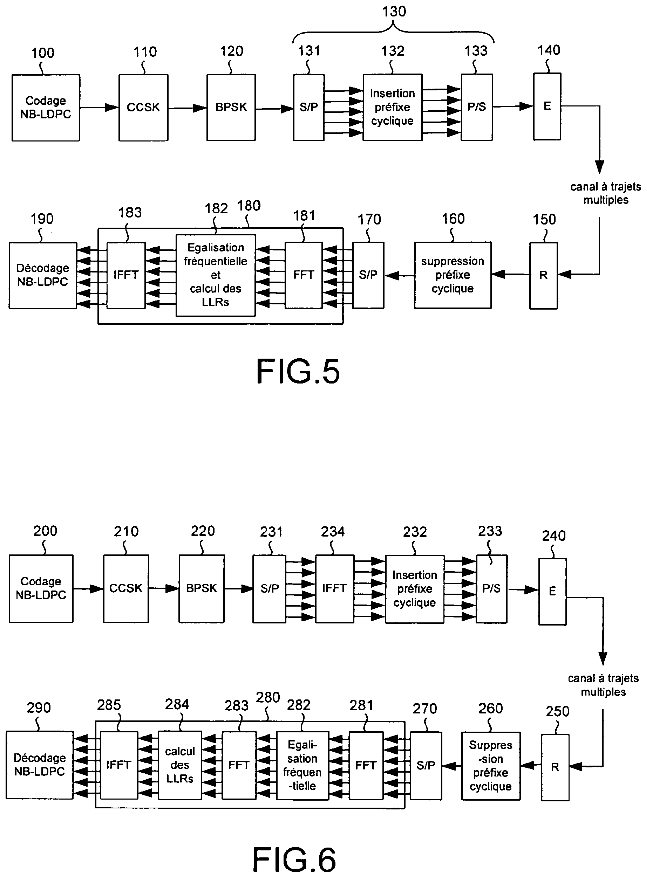

Cet avantage est illustré par les figures 5 et 6 qui représentent respectivement le schéma fonctionnel d'un système SC-FDE et le schéma fonctionnel d'un système OFDM, ces deux systèmes comportant une étape de modulation CCSK et une étape d'égalisation.

Dans les deux systèmes, un codeur NB-LDPC effectue une étape de codage (étape 100 pour le système SC-FDE; étape 200 pour le système OFDM). Cette étape de codage consiste notamment à rajouter de la redondance dans les données d'entrée de manière à générer des mots de code comprenant chacun un nombre prédéterminé de symboles du corps de Galois GF(q). Chaque symbole de mot de code est ensuite converti (étape 110; étape 210) en une séquence CCSK ayant une longueur supérieure ou égale à q bribes. Les séquences CCSK sont ensuite utilisées pour moduler une porteuse pendant une étape de modulation BPSK (étape 120; étape 220).

Dans le système SC-FDE (figure 5), une insertion de préfixe cyclique CP (étape 130) est réalisée après l'étape de modulation de porteuse. Cette étape comprend une étape 131 de conversion série/parallèle, une étape 132 d'insertion de préfixe cyclique proprement dite et une étape 133 de conversion inverse. Le préfixe cyclique CP est ainsi ajouté directement à chaque symbole modulé en BPSK, appelé symbole SC.

Dans le système OFDM (figure 6), après conversion série/parallèle (étape 231), une transformée de Fourier rapide Inverse à q points (étape 234) est appliquée à la séquence CCSK modulée BPSK pour obtenir des symboles OFDM de q éléments auxquels on ajoute un préfixe cyclique (étape 232). Une conversion parallèle série (étape 233) est réalisée ensuite après l'insertion. Dans les deux systèmes, le préfixe cyclique est une extension de symbole obtenue en copiant les derniers éléments de chaque symbole SC ou OFDM et à les placer devant le symbole. La longueur du préfixe cyclique est de préférence supérieure au retard maximum du canal à trajets multiples. L'effet des interférences inter-symbole engendrées par un symbole sur le symbole suivant est alors confiné à l'intérieur du préfixe cyclique de ce dernier de sorte qu'il n'affectera pas la FFT du symbole suivant. Les symboles SC et OFDM sont ensuite transmis (étape 140; étape 240) à travers un canal à trajets multiples vers un récepteur distant. Une fois le préfixe cyclique supprimé en réception, le signal reçu est convolué circulairement avec la réponse impulsionnelle du canal de sorte que l'égalisation fréquentielle se fait en divisant la transformée de Fourier rapide du signal reçu par la fonction de transfert du canal.

Le récepteur reçoit (étape 150 pour le système SC-FDE; étape 250 pour le système OFDM) les symboles transmis puis effectue une étape de suppression de préfixe cyclique (étape 160; étape 260), une étape de conversion série-parallèle (étape 170; étape 270) précédant une étape globale d'égalisation et de calcul des valeurs LLR (étape 180; étape 280). Les valeurs LLR calculées sont ensuite décodées par décodeur NB-LDPC (étape 190; étape 290).

Les étapes 180 et 280 d'égalisation et de calcul des valeurs LLR sont différentes. Dans le système SC-FDE, l'étape 180 comporte une étape 181 unique de FFT servant à la fois à l'égalisation et au calcul des valeurs de LLR (étape 182). Une opération IFFT (étape 183) est ensuite appliquée pour obtenir les valeurs de LLR. Dans le système OFDM, l'étape 280 comporte deux étapes FFT, une première étape FFT 281 précédant l'étape d'égalisation 282 et une deuxième étape de FFT 283 précédant l'étape de calcul des valeurs de LLR 284. Une étape de IFFT 285 est enfin appliquée pour obtenir les valeurs de LLR.

L'égalisation et le calcul des valeurs de LLR sont décrits ci-après pour les deux systèmes. Pour ces étapes, on utilise les notations suivantes:

- x désigne la séquence CCSK modulée en BPSK;
- $x_{OFDM}$ = IFFT(x) est le symbole OFDM associé à x;
- $x_{SC}$ = x est le symbole SC;
- $y_{OFDM}$ est le symbole OFDM reçu après suppression du préfixe cyclique;
- $y_{SC}$ est le symbole SC reçu après suppression du préfixe cyclique;
- h est la réponse impulsionnelle du canal; et
- n est un vecteur de q réalisations de bruit gaussien complexe.

L'égalisation est de type MMSE (pour Minimum Mean Square Error en langue anglaise).

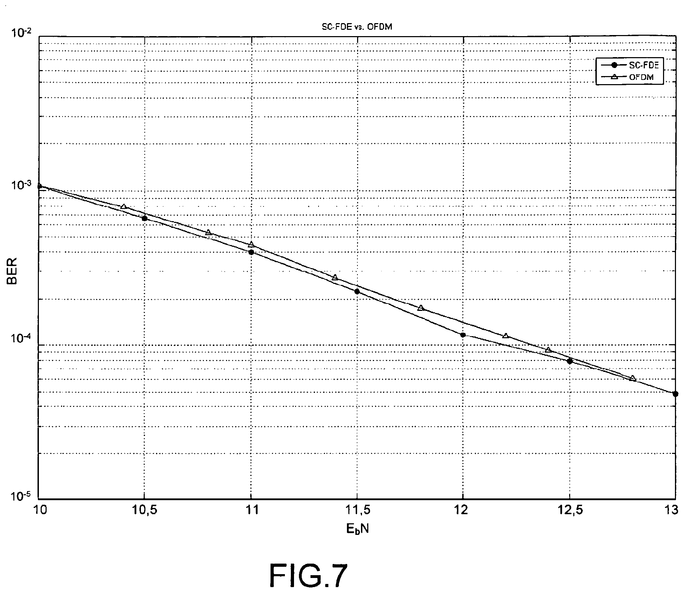

Dans le cas du système OFDM (Figure 7), le signal $y_{OFDM}$ obtenu après suppression du préfixe cyclique du signal reçu peut être écrit sous la forme suivante:

$$y_{OFDM}(i) = \sum_{j=0}^{D-1} h(j) \cdot x_{OFDM}(i - j \bmod q) + n(i) \quad \forall i \in [0, q-1]$$

où D est le retard maximum du canal.

Si on définit la FFT à q points de $y_{OFDM}$ par la relation $Y_{OFDM}(m) = FFT_m(y_{OFDM})$ où m est le $m^{ième}$ point de la FFT et la FFT de h par la relation $H(m) = FFT_m(h)$, alors le $m^{ième}$ coefficient d'égalisation MMSE est défini par la relation:

$$\beta_m = \frac{H(m)^*}{\|H(m)\| + q \cdot \sigma^2} \quad \forall m \in [0, q-1]$$

où $\sigma$ est la déviation du bruit gaussien.

Après égalisation, l'échantillon Y(m) devient l'échantillon Z(m) défini par la relation suivante:

$$Z(m) = \beta_m \cdot Y_{OFDM}(m) \quad \forall m \in [0, q-1]$$

Le calcul des corrélations est ensuite effectué dans le domaine fréquentiel. Les échantillons égalisés sont ainsi transposés dans le domaine fréquentiel par l'étape 283 et le calcul des corrélations est ensuite effectué en multipliant la FFT de Z par la FFT conjuguée de la séquence $PN_0$ modulée en BPSK. Le vecteur des valeurs de corrélation est obtenu au moyen de la IFFT. Enfin, une normalisation permet d'obtenir le vecteur des valeurs de LLR.

Dans le cas du système SC-FDE (Figure 6), le signal $y_{sc}$ obtenu en supprimant le préfixe cyclique du signal reçu peut être défini de la manière suivante:

$$y_{SC}(i) = \sum_{j=0}^{D-1} h(j) \cdot x_{SC}(i - j \bmod q) + n(i) \quad \forall i \in [0, q-1]$$

Le $m^{\text{ième}}$ coefficient d'égalisation MMSE est défini par la relation:

$$\beta_m = \frac{H(m)^*}{\|H(m)\| + \sigma^2} \quad \forall m \in [0, q-1]$$

Dans ce cas, le calcul des valeurs LLR peut être effectué en même temps que l'égalisation. Si on désigne le $m^{\text{ième}}$ coefficient de la transformée de Fourier rapide de la séquence $PN_0$ modulée en BPSK par $\gamma_m = FFT(PN_0)(m)$, l'égalisation et le calcul des valeurs de LLR sont réalisées par:

$$Z(m) = \gamma_m \cdot \beta_m \cdot Y_{SC}(m) \quad \forall m \in [0, q-1]$$

Le vecteur de valeurs de corrélation est ensuite obtenu en appliquant à Z une IFFT (étape 285). Le vecteur des valeurs de LLR est obtenu en normalisant le vecteur des valeurs de corrélation.

Ainsi, dans le cas d'un système à porteuse unique, l'étape d'égalisation fréquentielle et l'étape de calcul des valeurs des corrélations peuvent être fusionnées en une étape unique. Une seule étape de FFT est alors nécessaire en réception. L'utilisation de la modulation CCSK est donc particulièrement avantageuse dans les systèmes à porteuse unique.

La figure 7 illustre les performances de décodage de ces deux systèmes SC-FDE et OFDM. Cette figure représente des résultats de simulation sous forme de courbes. Une première courbe représente les résultats du système OFDM et une deuxième courbe représente les résultats du système SC-FDE. Le code LDPC utilisé est défini sur GF(64), de longueur 1008 bits et de rendement 1/2. L'algorithme EMS possède les mêmes paramètres que ceux employés pour les simulations de la figure 4. On observe que les performances en termes de taux d'erreur binaire BER sont quasi-identiques dans les deux systèmes.

Il en résulte que, compte tenu de leur faible coût d'implémentation (1 seul générateur pseudo-aléatoire en émission; une seule opération de FFT en réception), les systèmes à porteuse unique employant des codes NB-LDPC et une modulation CCSK peuvent être considérés comme une solution très intéressante pour les systèmes de communication sans fil du futur. Ces systèmes présentent par ailleurs un facteur crête, noté couramment PAPR (pour Peak-to-Average Power ratio en langue anglaise), plus faible que les systèmes OFDM. Cela permet de réduire la puissance d'émission des signaux et d'employer des amplificateurs plus petits et moins chers fonctionnant linéairement sur toute la gamme de variation du signal par rapport aux systèmes OFDM. Cela permet également de réduire la consommation électrique du système.

## Revendications

**1.** Procédé de transmission de symboles de mot de code correcteur d'erreur non binaire à travers un canal de transmission, chaque symbole de mot de code comprenant p bits, lequel procédé comprend

- une première étape de modulation (110) associant à chaque symbole de mot de code de p bits une séquence d'au moins $2^P$ bribes parmi $2^P$ séquences possibles,
- une deuxième étape de modulation (120) pour moduler la phase ou l'amplitude d'au moins une porteuse avec les séquences associées aux mots de code et générer des symboles modulés, et
- une étape de transmission (140) de la porteuse modulée à travers ledit canal de transmission,

dans lequel la première étape de modulation est une modulation à étalement de spectre de type modulation par décalage de code cyclique utilisant une séquence pseudo-aléatoire de base d'au moins $2^P$ bribes, les $2^P$ séquences possibles étant obtenues par décalage circulaire de la séquence pseudo-aléatoire de base et **caractérisé en ce que** les symboles modulés générés lors de la deuxième étape de modulation sont de taille égale à celle des séquences, et

**en ce que** le procédé comprend en outre, après ladite deuxième étape de modulation, une étape d'insertion d'un préfixe cyclique (130) dans chaque symbole à transmettre.

**2.** Dispositif d'émission de symboles de mots de code correcteur d'erreur non binaire à travers un canal de transmission selon le procédé de transmission de la revendication 1, chaque symbole de mot de code comprenant p bits, lequel dispositif comprend

- un premier modulateur configuré pour associer à chaque symbole de mot de code de p bits une séquence d'au moins $2^P$ bribes parmi $2^P$ séquences possibles,
- un deuxième modulateur configuré pour moduler la phase ou l'amplitude d'une porteuse avec les séquences associées aux mots de code et générer des symboles modulés, et
- un émetteur configuré pour transmettre la porteuse modulée à travers ledit canal de transmission,

dans lequel le premier modulateur est un modulateur à étalement de spectre de type à décalage de code cyclique utilisant une séquence pseudo-aléatoire de base d'au moins $2^P$ bribes, les $2^P$ séquences possibles étant obtenues par décalage circulaire de la séquence pseudo-aléatoire de base, et

**caractérisé en ce que** le deuxième modulateur est configuré de sorte que les symboles modulés générés sont de taille égale à celle des séquences, et

**en ce que** le dispositif comporte en outre un circuit apte à insérer un préfixe cyclique dans chaque symbole à transmettre.

**3.** Signal de code correcteur d'erreur non binaire destiné à être transmis selon le procédé de transmission de la revendication 1.

**4.** Procédé de réception d'un signal de code correcteur d'erreur non binaire conforme à la revendication 3 et transmis sur une porteuse unique, comprenant:

- une étape de réception (150) du signal,
- une étape (160) de suppression du préfixe cyclique de chaque symbole transmis;
- une étape de transformée de Fourier rapide (181) du signal reçu pour générer des échantillons dans le domaine fréquentiel, et
- une étape d'égalisation fréquentielle et de calcul de valeurs de logarithmes de rapport de vraisemblance (182) desdits échantillons.

**5.** Dispositif de réception d'un signal de code correcteur d'erreur non binaire conforme à la revendication 3 et transmis sur une porteuse unique, comprenant:

- un récepteur du signal transmis,
- un circuit apte à supprimer le préfixe cyclique de chaque symbole transmis,
- un circuit de transformée de Fourier rapide du signal reçu configuré pour générer des échantillons dans le domaine fréquentiel, et
- un circuit d'égalisation fréquentielle et de calcul de valeurs de logarithmes de rapport de vraisemblance desdits échantillons.

**Patentansprüche**

**1.** Verfahren zur Übertragung von Symbolen nicht-binärer Fehlerkorrektur-Codewörter über einen Übertragungskanal, wobei jedes Symbol eines Codeworts p Bits umfasst, wobei das Verfahren umfasst:

- einen ersten Modulationsschritt (110), welcher jedem Symbol eines Codeworts von p Bits eine Sequenz von wenigstens $2^p$ Teilen aus $2^p$ möglichen Sequenzen zuordnet,
- einen zweiten Modulationsschritt (120) zum Modulieren der Phase oder der Amplitude von wenigstens einem Träger mit den dem Codewort zugeordneten Sequenzen und Erzeugen von modulierten Symbolen, und
- einen Übertragungsschritt (140) des modulierten Trägers über den Übertragungskanal,

wobei der erste Modulationsschritt eine Modulation durch Verteilen eines Spektrums vom Typ eines zyklischen Verschiebens von Code ist, welcher eine pseudo-zufällige Basissequenz der wenigstens $2^p$ Teile verwendet, wobei die $2^p$ möglichen Sequenzen durch zirkuläres Verschieben der pseudo-zufälligen Basissequenz erhalten werden, und

**dadurch gekennzeichnet, dass** die modulierten Symbole, welche während des zweiten Modulationsschritts erhalten werden, von einer Größe gleich derjenigen der Sequenzen sind, und

dadurch, dass das Verfahren ferner nach dem zweiten Modulationsschritt einen Schritt eines Einfügens eines zyklischen Präfixes (130) in jedes zu übertragende Symbol umfasst.

2. Vorrichtung zur Ausgabe von Symbolen nicht-binärer Fehlerkorrektur-Codewörter über einen Übertragungskanal gemäß dem Verfahren zur Übertragung nach Anspruch 1,
   wobei jedes Symbol eines Codeworts p Bits umfasst, wobei die Vorrichtung umfasst:

   - einen ersten Modulator, welcher dazu eingerichtet ist, jedem Symbol eines Codeworts von p Bits eine Sequenz von wenigstens $2^p$ Teilen aus $2^p$ möglichen Sequenzen zuzuordnen,
   - einen zweiten Modulator, welcher dazu eingerichtet ist, die Phase oder die Amplitude eines Trägers mit den Sequenzen zu modulieren, welche den Codewörtern zugeordnet sind, und Erzeugen von modulierten Symbolen, und
   - eine Ausgabeeinheit, welche dazu eingerichtet ist, den modulierten Träger über den Übertragungskanal zu übertragen,
   wobei der erste Modulator ein Modulator zum Verteilen eines Spektrum vom Typ eines zyklischen Verschiebens von Code ist, welcher eine pseudo-zufällige Basissequenz der wenigstens $2^p$ Teile verwendet, wobei die $2^p$ möglichen Sequenzen durch zirkuläres Verschieben der pseudo-zufälligen Basissequenz erhalten werden, und
   **dadurch gekennzeichnet, dass** der zweite Modulator derart eingerichtet ist, dass die erzeugten modulierten Symbole von einer Größe gleich derjenigen der Sequenzen sind, und
   dadurch, dass die Vorrichtung ferner eine Schaltung umfasst, welche in der Lage ist, einen zyklischen Präfix in jedes zu übertragende Symbol einzufügen.

3. Signal eines nicht-binären Fehlerkorrektur-Codes, welches dazu vorgesehen ist, gemäß dem Übertragungsverfahren nach Anspruch 1 übertragen zu werden.

4. Verfahren zum Empfangen eines Signal eines nicht-binären Fehlerkorrektur-Codes in Übereinstimmung mit Anspruch 3 und auf einem einzelnen Träger übertragen, umfassend:

   - einen Schritt eines Empfangens (150) des Signals,
   - einen Schritt (160) eines Beseitigens des zyklischen Präfixes von jedem übertragenen Symbol;
   - einen Schritt einer schnellen Fourier-Transformation (181) des empfangenen Signals zum Erzeugen von Werten in der Frequenzdomäne, und
   - einen Schritt eines Frequenz-Ausgleichens und eines Berechnens von Werten von Logarithmen im Zusammenhang mit einer Wahrscheinlichkeit (182) der Werte.

5. Vorrichtung zum Empfangen eines Signal eines nicht-binären Fehlerkorrektur-Codes nach Anspruch 3 und auf einem einzelnen Träger übertragen, umfassend:

   - eine Empfangseinheit für das übertragene Signal,
   - eine Schaltung, welche geeignet ist, den zyklischen Präfix von jedem übertragenen Symbol zu beseitigen,
   - eine Schaltung für eine schnelle Fourier-Transformation des empfangenen Signals, welche dazu eingerichtet ist, Werte in der Frequenzdomäne zu erzeugen, und
   - eine Schaltung zum Frequenzausgleichen und zum Berechnen von Werten von Logarithmen im Zusammenhang mit einer Wahrscheinlichkeit der Werte.

**Claims**

1. A method for transmitting non binary error correcting code word symbols via a transmission channel, each code word symbol comprising p bits, which method comprises

   - a first modulation step (110) associating with each code word symbol of p bits a sequence of at least $2^P$ chips from $2^P$ possible sequences,
   - a second modulation step (120) to modulate the phase or amplitude of at least one carrier signal with the sequences associated with the code words and generate modulated symbols, and

- a step (140) of transmitting the modulated carrier signal via said transmission channel, wherein the first modulation step is a spread spectrum modulation of the cyclic code shift keying type using a basic pseudo-random sequence of at least $2^P$ chips, the possible $2^P$ sequences being obtained by circular shift of the basic pseudo-random sequence and

**characterised in that** the modulated symbols generated during the second modulation step are of size equal to that of the sequences, and

**in that** the method further comprises, after said second modulation step, a step of inserting a cyclic prefix (130) into each symbol to be transmitted.

2. A device for emitting non binary error correcting code word symbols via a transmission channel according to the transmission method of claim 1, each code word symbol comprising p bits, which device comprises

- a first modulator configured to associate with each code word symbol of p bits a sequence of at least $2^P$ chips from $2^P$ possible sequences,
- a second modulator configured to modulate the phase or the amplitude of a carrier signal with the sequences associated with the code words and generate modulated symbols, and
- an emitter configured to transmit the modulated carrier signal via said transmission channel,

wherein the first modulator is a spread spectrum modulator of the type with a cyclic code shift keying using a basic pseudo-random sequence of at least $2^P$ chips, the $2^P$ possible sequences being obtained by circular shift of the basic pseudo-random sequence, and

**characterised in that** the second modulator is configured so that the generated modulated symbols are of size equal to that of the sequences, and

**in that** the device further includes a circuit capable of inserting a cyclic prefix into each symbol to be transmitted.

3. A non binary error correcting code signal intended to be transmitted according to the transmission method of claim 1.

4. A method for receiving a non binary error correcting code signal according to claim 3 and transmitted on a single carrier signal, comprising:

- a step (150) of reception of the signal,
- a step of removal (160) of the cyclic prefix from each symbol transmitted;
- a step of fast Fourier transform (181) of the received signal to generate samples in the frequency domain, and
- a step of frequency equalisation and of calculation of values of likelihood ratio logarithms (182) of said samples.

5. A device for receiving a non binary error correcting code signal in accordance with claim 3 and transmitted on a single carrier signal, comprising:

- a receiver of the transmitted signal,
- a circuit capable of removing the cyclic prefix from each symbol transmitted,
- a circuit of fast Fourier transform of the received signal configured to generate samples in the frequency domain, and
- a circuit of frequency equalisation and calculation of values of likelihood ratio logarithms of said samples.

**FIG.1**

**FIG.2**

**FIG.3**

FIG.4

FIG.5

FIG.6

FIG.7

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **YU-ZHEN HUANG ; YUN-PENG CHENG ; YU-MING ZHANG ; GUO-HAI YU ; JIN CHEN.** Combine Non-Binary LDPC codes with M-ary Orthogonal spread spectrum modulation. *2010 International Conférence on Wireless Communications and Signal Processing (WCSP),* 2010

- **CHI-HAN KAO et al.** *Performance analysis and simulations of 32-ary cyclic code-shift keying*
- **A.VOICILA ; D.DECLERCQ ; M.FOSSORIER ; F.VERDIER.** Algorithmes simplifiés pour le décodage de codes LDPC non binaires. *GRETSI,* Septembre 2005